Europäisches Patentamt

European Patent Office

Office européen des brevets

(11) Publication number: **0 144 444 B1**

# EUROPEAN PATENT SPECIFICATION

(45) Date of publication of patent specification: **26.02.92** (51) Int. Cl.5: **H01L 29/72**

(21) Application number: **84902071.4**

(22) Date of filing: **25.05.84**

(86) International application number:
**PCT/JP84/00271**

(87) International publication number:
**WO 84/04853 (06.12.84 84/28)**

(54) **METHOD OF MANUFACTURING SEMICONDUCTOR DEVICE.**

(30) Priority: **26.05.83 JP 92697/83**

(43) Date of publication of application:
**19.06.85 Bulletin 85/25**

(45) Publication of the grant of the patent:
**26.02.92 Bulletin 92/09**

(84) Designated Contracting States:
**DE FR GB NL**

(56) References cited:
**EP-A- 0 045 848**
**JP-A- 5 011 676**
**JP-A- 5 539 677**
**US-A- 4 251 300**

**JAPANESE JOURNAL OF APPLIED PHYSICS, vol. 19, supplement 19-1, 1980, pages 181-185, Tokyo, JP; H. SAKURAI et al.: "A new transistor structure for high speed bipolar LSI"**

**EXTENDED ABSTRACTS OF THE JOURNAL**

**OF THE ELECTROCHEMICAL SOCIETY, vol. 73-1, 1973, pages 426-428, abstract no. 172, Princeton, US; R. EDWARDS et al.: "Oxide isolation technology featuring ion implantation and partially self-registered emitters"**

(73) Proprietor: **SONY CORPORATION**
**7-35 Kitashinagawa 6-Chome Shinagawa-ku Tokyo 141(JP)**

(72) Inventor: **OUCHI, Norikazu Sony Corporation**
**7-35, Kitashinagawa 6-chome**
**Shinagawa-ku Tokyo 141(JP)**
Inventor: **KAYANUMA, Akio Sony Corporation**
**7-35, Kitashinagawa 6-chome Shinagawa-ku Tokyo 141(JP)**
Inventor: **ASANO, Katsuaki Sony Corporation**
**7-35, Kitashinagawa 6-chome**
**Shinagawa-ku Tokyo 141(JP)**

(74) Representative: **Cotter, Ivan John et al**
**D. YOUNG & CO. 10 Staple Inn**
**London WC1V 7RD(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to methods of manufacturing bipolar transistors.

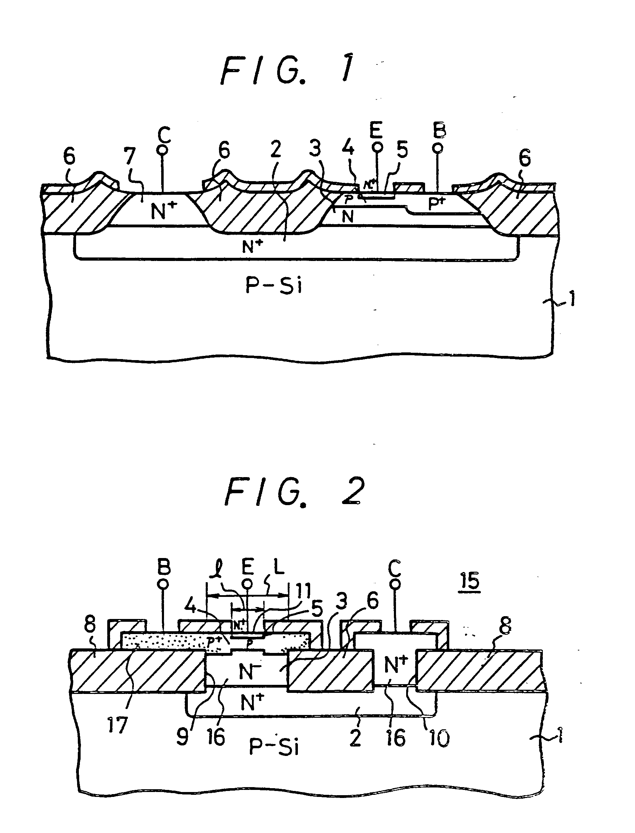

Previously proposed methods of separating elements of a semiconductor integrated circuit (IC) include, for example, a selective oxidation (LOCOS) method. Figure 1 of the accompanying drawings is a cross-sectional view of a main part of a bipolar transistor integrated circuit (IC) manufactured by using the selective oxidation method. The structure shown in Figure 1 comprises a silicon semiconductor substrate 1 of, for example, P type, a collector embedded layer 2 of $N^+$ type, a collector region 3 formed as an N type epitaxial growth layer, a base region 4, an emitter region 5, an $SiO_2$ layer 6 formed by the selective oxidation method, a portion 7 from which a collector electrode is led out, and terminals C, E and B for the collector, emitter and base, respectively.

The selective oxidation process used for manufacturing the bipolar transistor IC of Figure 1 has the following problems. If a so-called bird's beak (the bird's beak protrudes by approximately one micrometre) and a so-called bird's head are generated as shown in Figure 1, when a window is opened upon carrying out the selective oxidation process and a window is opened for the emitter region, respective mask alignments are necessary; in this case, a tolerance including the alignment precision and the bird's beak is necessary; since the spacing between the base electrode leading-out portion and the emitter electrode leading-out portion is determined by the tolerance of an Al electrode, there is a limit to making the spacing narrow; the parasitic capacitance of the collector is considerably affected by the region except for the active region (so-called intrinsic portion); and the above problems impose a limit on making the cell size smaller, etc.

In order to solve such problems, the present applicants have proposed (see Japanese Patent Application No. 62701/1983) a method of manufacturing a bipolar transistor IC as shown in Figure 2 of the accompanying drawings. In this manufacturing method, an $N^+$ type collector embedded layer 2 is formed first in a silicon semiconductive substrate 1 of, for example, P type. Thereafter, window apertures 9 and 10 are selectively formed through predetermined portions of an insulating film, for example an $SiO_2$ film 8, on the major surface of the substrate, namely portions corresponding to the active region and the collector electrode leading-out portion of the transistor. Then, the whole surface including the $SiO_2$ film 8 and the window apertures 9 and 10 is subjected to vapour phase growth treatment, whereby single crystal (monocrystalline) silicon 16 is formed within the window apertures 9 and 10 and polycrystalline silicon 17 is formed on the $SiO_2$ layer 8. Thereafter, the monocrystalline silicon 16 and the polycrystalline silicon 17 are flattened and the polycrystalline silicon 17 is selectively removed. Then, an $N^-$ type collector region 3, a P type base region 4 and an $N^+$ type emitter region 5 are formed on the monocrystalline silicon 16 within the window aperture 9 and the polycrystalline silicon 17 acts as the base electrode lead-out portion, while an $N^+$ type collector electrode lead-out portion is formed on the monocrystalline silicon 16 within the other window aperture 10, whereby a bipolar transistor IC is formed. According to this manufacturing method, no bird's beak and no bird's head are produced, the parasitic capacitance of the collector can be reduced, the cell size can be decreased, etc. However, as will be clear from Figure 2, although the base region 4, the emitter region 5 and the emitter electrode lead-out portion 11 are formed in a self-alignment fashion, there is a difference in size as represented as L and l between the collector region 3 and the base region 4 and they cannot be formed in a self-alignment fashion, whereby alignment precision and tolerance are still required.

European Patent Application Publication No. EP-A-0 045 848 discloses a method of manufacturing a bipolar transistor (3) having an active region which comprises a collector region (12), a base region (34) and an emitter region (32), the method comprising:

forming, at a surface of a semiconductive substrate (10) of first conductivity type (P), an embedded region (12) of the opposite conductivity type (N);

forming on said surface of the substrate (10) a first insulative layer (14) having therein first and second openings that open to the embedded region (12);

forming over the first insulative layer (14) a semiconductive layer (18) that comprises monocrystalline first and second recessed regions (18B) in the first and second openings, respectively, and is polycrystalline elsewhere (18A), the semiconductive layer being of said opposite conductivity type (N);

forming a second insulative layer (20) and then a nitride layer (22) within the recessed regions (18B) of the semiconductive layer;

ion-implanting an impurity of said first conductivity type (P) into the semiconductive layer;

forming an oxide layer (28) over the semiconductive layer using the nitride layer (22) as a mask, and then removing the nitride layer (22) and the second insulative layer (20); and

introducing impurities of said first and opposite conductivity types into said active region to form the base region (48) of said first conductivity type and the emitter region (47) of the opposite conductivity type, using the oxide layer (39) as a mask.

According to the present invention there is provided a method of manufacturing a bipolar transistor having an active region which comprises a collector region, a base region and an emitter region, and an emitter electrode lead-out region, the collector, base, emitter and emitter electrode lead-out regions being formed in a self-aligned fashion, the method comprising:

forming, at a surface of a semiconductive substrate of first conductivity type, an embedded region of the opposite conductivity type;

forming on said surface of the substrate a first insulative layer having therein first and second openings that open to the embedded region;

forming over the first insulative layer a semiconductive layer that comprises monocrystalline first and second recessed regions in the first and second openings, respectively, and is polycrystalline elsewhere, the semiconductive layer being of said opposite conductivity type;

enriching the second monocrystalline recessed region of the semiconductive layer of said opposite conductivity type with an impurity of said opposite conductivity type to form a collector electrode lead-out portion in the second opening;

forming a second insulative layer and then a nitride layer within the recessed regions of the semiconductive layer;

ion-implanting an impurity of said first conductivity type into the semiconductive layer and then selectively removing the semiconductive layer to form: a first semiconductive layer part that comprises the active region, which is within the first opening, and a base electrode lead-out portion that extends away from the first opening; and a second semiconductive part that comprises said collector electrode lead-out portion;

the second insulative layer and the nitride layer serving as an ion-stopper to prevent ions being implanted into the active region during the ion implantation, whereby the collector region remains of said opposite conductivity type;

forming an oxide layer over said first and second semiconductive layer parts using the nitride layer as a mask, and then removing the nitride layer;

introducing an impurity of said first conductivity type into said active region to form the base region of said first conductivity type, using the oxide layer as a mask;

removing the second insulative layer; and

introducing an impurity of said opposite conductivity type into the base region to form the emitter region of the opposite conductivity type.

A preferred embodiment of the invention described hereinbelow provides a method of manufacturing a bipolar transistor capable of at least partially solving the above-described problem of the separation between the elements caused by the selective oxidation method and in which the collector, base and emitter regions and the emitter electrode lead-out region or portion are formed in a self-alignment fashion so as to permit the elements to be smaller and an IC device of high efficiency and high integration density to be manufactured.

The invention will now be further described, by way of illustrative and non-limiting example, with reference to the accompanying drawings, in which:

Figures 1 and 2 are cross-sectional views of bipolar transistors manufactured by previously proposed manufacturing methods;

Figures 3A to 3M are cross-sectional views of successive stages in the manufacture of a bipolar transistor by a method embodying the invention; and

Figure 4 is an enlarged partial cross-sectional view of a bipolar transistor manufactured by the method embodying the invention.

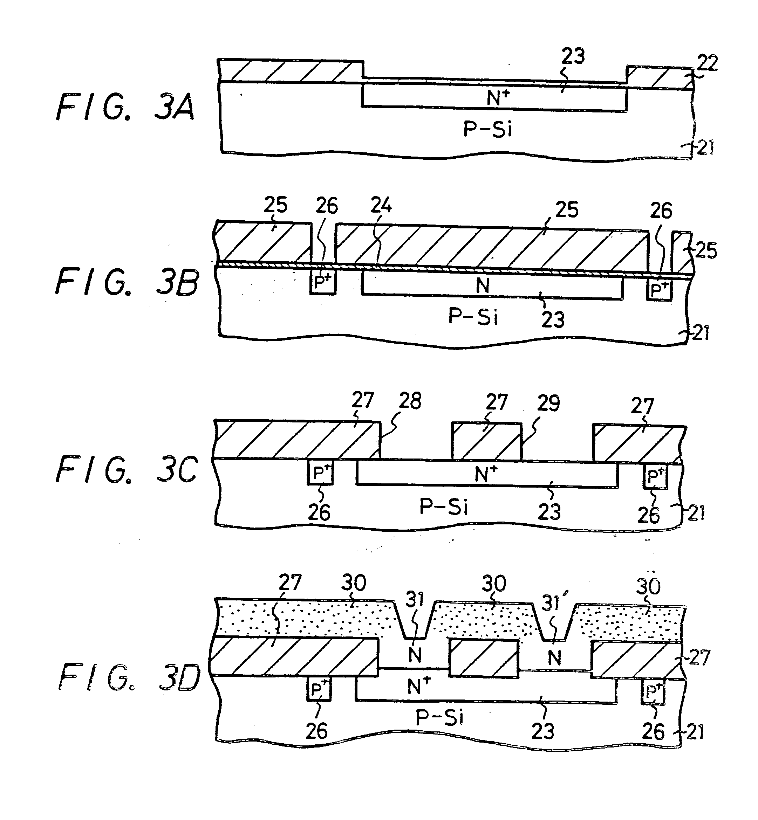

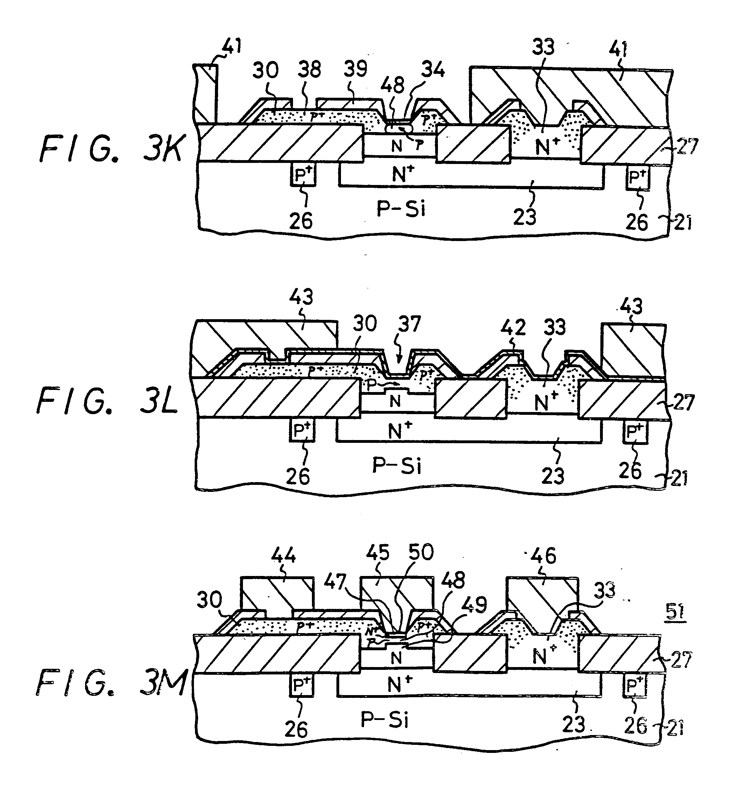

A method embodying the invention for manufacturing a bipolar transistor will now be described with reference to Figures 3A to 3M. In this embodiment, the invention is used to manufacture an NPN transistor. The invention can, however, also be used to manufacture a PNP transistor.

In the illustrated embodiment, as shown in Figure 3A, after an oxide ($SiO_2$) layer 22 is formed on a P type silicon semiconductive substrate 21, a window is formed through the oxide layer 22 and an N type impurity is diffused into the substrate 21 through the window so as to form an N type collector embedded layer 23.

Then, as shown in Figure 3B, the oxide layer 22 is removed by etching and a thin oxide ($SiO_2$) layer 24 is formed in place thereof. Using a photo resist 25 which is deposited on the oxide layer 24 as a mask, a P type impurity is implanted in the substrate 21 so as to form a channel stopper embedded layer 26 therein.

Next, as shown in Figure 3C, an $SiO_2$ layer 27 is formed on the substrate 21 by a CVD (chemical vapour deposition) technique, and a reactive ion etching (RIE) technique or the like is then used to form openings (open portions) 28 and 29 at predetermined positions of the $SiO_2$ layer 27, namely portions corresponding to an active region and a collector electrode lead-out portion.

Then, as shown in Figure 3D, $SiH_4$ is used to carry out vapour growth, thereby to form an N type polycrystalline silicon layer 30 on the $SiO_2$ layer 27 and to form N type monocrystalline silicon epitaxial layers 31 and 31' in the open portions 28 and 29, respectively. Since the polycrystalline silicon layer 30 and the epitaxial layers 31 and 31' formed by the vapour growth are substantially equal in thickness to one another, the portions corresponding to the open portions 28 and 29 are formed as concave (that is, recessed) portions. Such configuration can be obtained if the crystal surface of the substrate is of either of the Miller indices (100) and (111).

Next, as shown in Figure 3E, using a photo resist layer 32 as a mask, an N type impurity is implanted into the epitaxial layer 31' formed within the open portion 29. Thereafter, drive-in diffusion is carried out to form a collector electrode leading-out portion 33 of low resistance.

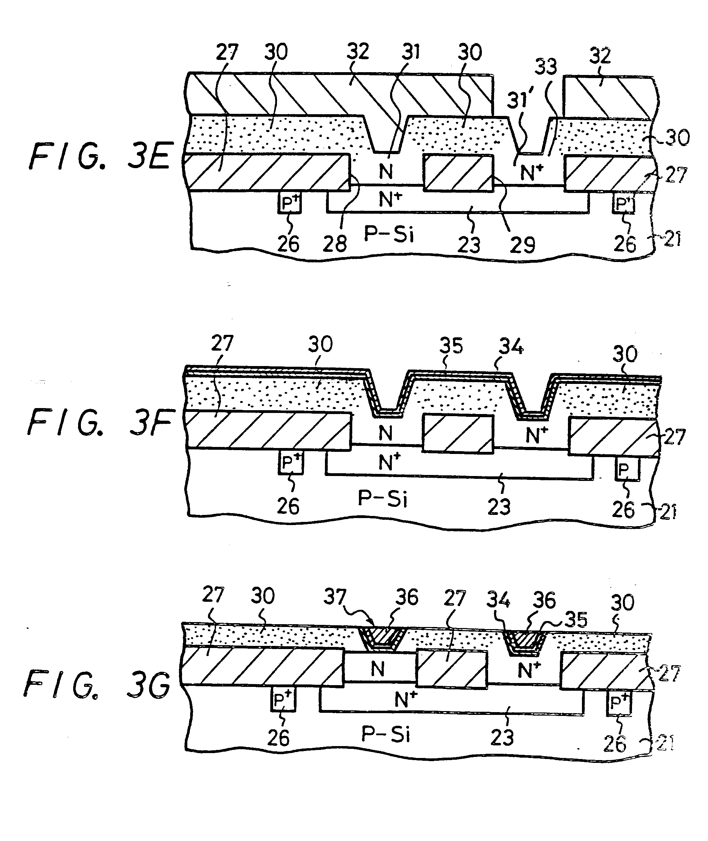

Then, as shown in Figure 3F, the photo resist layer 32 is removed, after which a thin oxide ($SiO_2$) film or layer 34 and a nitride layer (SiN) 35 are deposited by the CVD technique. The thickness of the oxide film 34 is preferably in a range of from 200 to 500 angstroms.

Next, as shown in Figure 3G, a photo resist 36 is deposited and the surface of the substrate 21 is made flat by an ion milling or a reactive ion etching technique, after which the polycrystalline silicon layer 30 is abraded away to some extent. Since the size of a concave portion 37 is usually not higher than several micron squares, the layer can be made flat with ease. In this case, the etching technique can be carried out with good control.

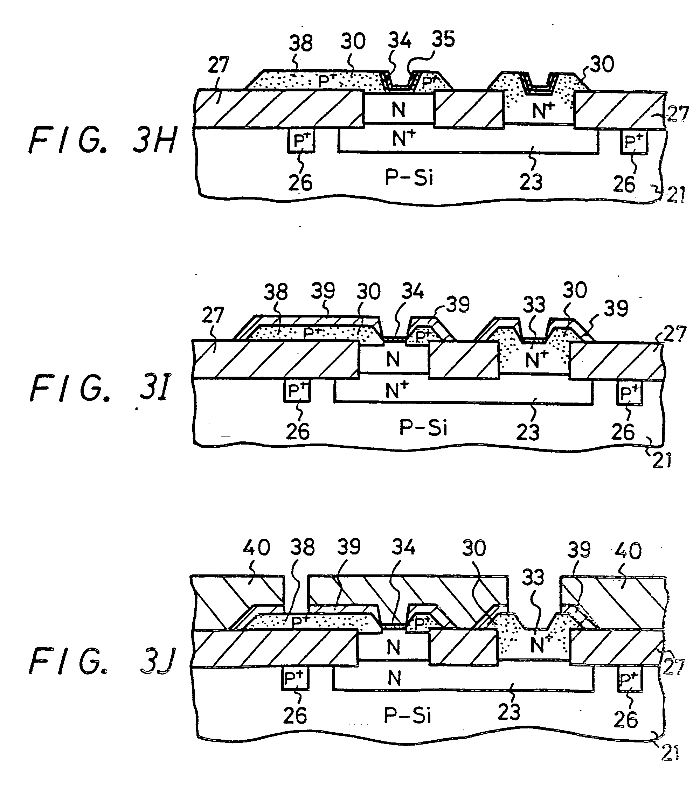

Then, as shown in Figure 3H, a P type impurity is ion-implanted into the polycrystalline silicon layer 30. The laminated member formed of the thin oxide film 34, the nitride layer 35 and the photo resist 36 in the concave portion 37 acts as a stopper against the ion-implantation so that no ions are implanted into the active region. Thereafter, the photo resist 36 and undesired areas of the polycrystalline silicon layer 30 (areas except for predetermined regions or parts) are removed by an etching technique to thereby form a base electrode leading-out portion 38. After the etching of the polycrystalline silicon layer 30, an annealing treatment is carried out for diffusion. If the treatments are carried out in the above sequential order, then, as shown in Figure 3H, by the influence of damage caused by the ion-milling and the ion-implantation, the polycrystalline silicon layer 30 is etched to be a taper-shape so that the polycrystalline silicon layer 30 becomes of a shape which is advantageous for subsequent Al wiring. On the other hand, if the annealing treatment is carried out before the undesired areas of the polycrystalline layer 30 are removed, the polycrystalline silicon layer 30 is not etched to be a taper-shape.

Then, as shown in Figure 3I, using the nitride layer 35 as a mask, an oxide ($SiO_2$) layer 39 (having a thickness equal to or greater than 3000 angstroms) is selectively formed on the surface of the polycrystalline silicon layer 30. Thereafter, the nitride layer 35 is removed. By removing the nitride layer 35, a window for forming the base region and the emitter region and a window for the collector electrode leading-out portion 33 can be formed automatically.

Next, as shown in Figure 3J, using a photo resist 40 as a mask, a window for the base electrode leading-out portion 38 is formed in the oxide layer 39 and, at the same time, the open portion of the oxide layer 39 on the collector electrode leading-out portion 33 is widened a little.

Next, as shown in Figure 3K, the collector electrode leading-out portion 33 is masked by a photo resist 41 and a P type impurity is ion-implanted into the active region to thereby form a base region 48. Ion-implantation into the base electrode leading-out portion 38 is carried out at the same time. Thereafter, an annealing treatment is carried out.

Then, as shown in Figure 3L, the oxide film 34 on the concave portion 37 is removed by an etching treatment, after which a polycrystalline silicon layer 42 for preventing Al from penetrating thereinto is formed by a CVD technique and the surface of the polycrystalline silicon layer 42 is oxidized to be as thin as required. Then, using a photo resist 43 as a mask, an N type impurity, (for example, arsenic (As)) is ion-implanted into the base region 48. Thereafter, an $SiO_2$ layer (not shown) for preventing out diffusion is formed by a CVD technique and then drive-in diffusion is carried out to form an emitter region 47. This $SiO_2$ layer is removed by an etching treatment and an annealing treatment is then carried out.

Then, as shown in Figure 3M, Al is deposited, a base electrode 44, an emitter electrode 45 and a collector electrode 46 are formed by an etching process and sintering is then carried out, whereby a desired bipolar transistor IC 51 is formed.

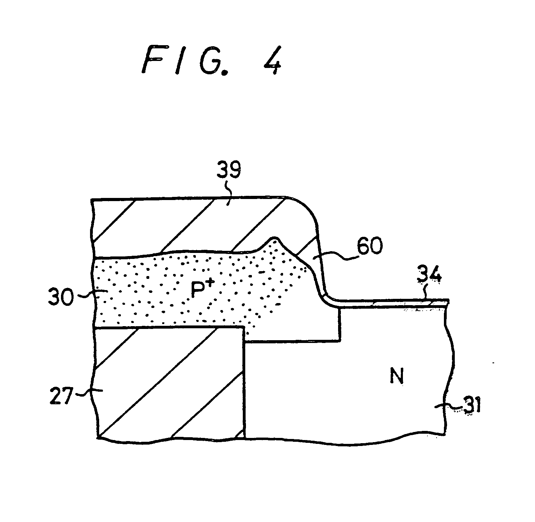

If, in the process stage as described above with reference to Figure 3I, the invaded amount of the bird's beak is small, as shown in Figure 4, not only the oxide layer on the bottom portion of the concave portion, but also the oxide layer at the side portions thereof, are removed by the etching in the following process of removing the oxide film 34 as described above with reference to Figure 3L. As a result, the portion between the emitter region and the base electrode leading-out portion is easily short-circuited, which becomes a serious problem when this is applied in practice to the semiconductor device. In the above embodiment, this problem can be solved by selecting the thickness of the oxide layer 34 having a thin under layer to be of an appropriate thickness ranging from 200 to 500 angstroms. However, in order to further stabilize the above portion, it is desirable for the following process stage to be added after the process stage of Figure 3I.

That is, after an Si₃N₄ layer or an SiO₂ layer is deposited by CVD or a polycrystalline silicon layer of good covering property which is laminated thinly by CVD is thermally oxidized, if such layer is etched by an ion-milling or a reactive ion-etching technique, on the basis of the shape of the concave portion, the side surface of the concave portion is not etched out, but only the bottom surface thereof is etched out, so that the window can be formed. Further, it is possible for the window portion to be directly nitrified and then masked so as to perform the selective oxidation treatment.

The embodiment of the invention described above provides a method for separating the elements for use instead of the previously proposed selective oxidation method which causes a problem since the bird's beak and bird's head are formed. In addition, when windows are formed through the SiO₂ layer 27 once in the process stage of Figure 3C, thereafter a collector region 49, the base region 48, the emitter region 47 and an emitter electrode leading-out region 50 can be formed in a self-alignment fashion. As a result, as compared with the previously proposed manufacturing method, the element can be made finer and the parasitic capacitance of the collector can be reduced, whereby a bipolar transistor IC of high efficiency and high integration density can be manufactured. In particular, in accordance with the manufacturing method embodying the invention, even if the minimum line width rule is in a range of from 2 to 3 micrometres, it is possible to form an emitter region of less than one micron square (that is, sub-micron square).

The method embodying the invention for manufacturing a bipolar transistor provides a method of separating the elements for use in place of the previously proposed selective oxidation method which gives rise to the problem that the bird's beak and bird's head are generated. In addition, the collector region, the base region, the emitter region and the emitter electrode leading-out region can be formed in a self-alignment fashion. Accordingly, as compared with the previously proposed manufacturing method, with the same line width rule as that of the previously proposed method, the parasitic capacitance of the collector can be decreased (accordingly, the portions except for the active region can be decreased), the cell size can be made small, an emitter region of less than one micron square can be manufactured, and so on. Thus, it is possible to manufacture a semiconductor device of high integration density and high efficiency.

## Claims

1.  A method of manufacturing a bipolar transistor (51) having an active region which comprises a collector region (49), a base region (48) and an emitter region (47), and an emitter electrode lead-out region (50), the collector, base, emitter and emitter electrode lead-out regions being formed in a self-aligned fashion, the method comprising:

forming, at a surface of a semiconductive substrate (21) of first conductivity type (P), an embedded region (23) of the opposite conductivity type (N);

forming on said surface of the substrate (21) a first insulative layer (27) having therein first and second openings (28, 29) that open to the embedded region (23);

forming over the first insulative layer (27) a semiconductive layer (30, 31, 31') that comprises monocrystalline first and second recessed regions (31, 31') in the first and second openings (28, 29), respectively, and is polycrystalline elsewhere (30), the semiconductive layer being of said opposite conductivity type (N);

enriching the second monocrystalline recessed region (31') of the semiconductive layer of said opposite conductivity type (N) with an impurity of said opposite conductivity type (N) to form a collector electrode lead-out portion (33) in the second opening (29);

forming a second insulative layer (34) and then a nitride layer (35) within the recessed regions (31, 31') of the semiconductive layer;

ion-implanting an impurity of said first conductivity type (P) into the semiconductive layer and then selectively removing the semiconductive layer to form: a first semiconductive layer part that comprises the active region, which is within the first opening (28), and a base electrode lead-out portion (38) that extends away from the first opening (28); and a second semiconductive part that comprises said collector electrode lead-out portion (33);

the second insulative layer (34) and the nitride layer (35) serving as an ion-stopper to prevent ions being implanted into the active region during the ion implantation, whereby the collector region (49) remains of said opposite conductivity type (N);

forming an oxide layer (39) over said first and second semiconductive layer parts using the nitride layer (35) as a mask, and then removing the nitride layer (35);

introducing an impurity of said first conductivity type (P) into said active region to form the base region (48) of said first conductivity type, using the oxide layer (39) as a mask;

removing the second insulative layer (34); and

introducing an impurity of said opposite conductivity type (N) into the base region (48) to form the emitter region (47) of the opposite conductivity type.

2. A method according to claim 1, wherein a polycrystalline silicon layer (42) for preventing the penetration of aluminium, used subsequently to form base, emitter and collector electrodes (44, 45, 46), is formed on the semiconductive layer after said removal of the second insulative layer (34).

## Revendications

1. Procédé de fabrication d'un transistor bipolaire (51) ayant une région active qui comprend une région de collecteur (49), une région de base (48), une région d'émetteur (47) et une région de production d'électrode d'émetteur (50), les régions de collecteur, de base, d'émetteur et de production d'électrode d'émetteur étant formées selon une méthode d'autoalignement, le procédé comprenant :

la formation, au niveau d'une surface d'un substrat semiconducteur (21) d'un premier type de conductivité (P), d'une région noyée (23) du type de conductivité opposé (N);

la formation sur ladite surface du substrat (21) d'une première couche isolante (27) ayant dedans des première et seconde ouvertures (28, 29) qui s'ouvrent sur la région noyée (23) ;

la formation sur la première couche isolante (27) d'une couche semiconductrice (30, 31, 31') qui comprend des première et seconde régions évidées monocristallines (31, 31') situées respectivement dans les première et seconde ouvertures (28, 29) et qui est sinon polycristalline (30), la couche semiconductrice étant du type de conductivité opposé (N) ;

l'enrichissement de la seconde région évidée monocristalline (31') de la couche semiconductrice dudit type de conductivité opposé (N) avec une impureté dudit type de conductivité opposé (N) afin de former une partie de production d'électrode de collecteur (33) dans la seconde ouverture (29) ;

la formation d'une seconde couche isolante (34) puis d'une couche en nitrure (35) dans les régions évidées (31, 31') de la couche semiconductrice ;

une implantation ionique d'une impureté dudit premier type de conductivité (P) dans la couche semiconductrice puis l'enlèvement de manière sélective de la couche semiconductrice pour former : une première partie de couche semiconductrice qui comprend la région active qui est à l'intérieur de la première ouverture (28) et une partie de production d'électrode de base (38) qui s'étend en s'éloignant de la première ouverture (28) ; et une seconde partie semiconductrice qui comprend ladite partie de production d'électrode de collecteur (33) ;

la seconde couche isolante (34) et la couche en nitrure (35) servant de barrières vis-à-vis des ions afin d'empêcher que ions ne soient implantés à l'intérieur de la région active lors de l'implantation ionique et ainsi, la région de collecteur (49) reste dudit type de conductivité opposé (N) ;

la formation d'une couche d'oxyde (39) sur lesdites première et seconde parties de couche semiconductrice en utilisant la couche en nitrure (35) en tant que masque puis en ôtant la couche en nitrure (35) ;

l'introduction d'une impureté dudit premier type de conductivité (P) dans ladite région active pour former la région de base (48) dudit premier type de conductivité en utilisant la couche en oxyde (39) en tant que masque ;

l'enlèvement de la seconde couche isolante (34) ; et

l'introduction d'une impureté dudit type de conductivité opposé (N) dans la région de base (48) pour former la région d'émetteur (47) du type de conductivité opposé.

2. Procédé selon la revendication 1, dans lequel une couche en silicium polycristallin (42) pour empêcher la pénétration de l'aluminium, cette couche étant utilisée ensuite pour former une base, des électrodes d'émetteur et de collecteur (44, 45, 46), est formée sur la couche semiconductrice après ledit enlèvement de la seconde couche isolante (34).

## Patentansprüche

1. Verfahren zum Herstellen eines bipolaren Transistors (51), der einen aktiven Bereich hat, welcher einen Kollektor-Bereich (49), einen Basis-Bereich (48) und einen Emitter-Bereich (47) sowie einen Emitterelektrodenherausführungs-Bereich (50) umfaßt, wobei die Kollektor-, Basis-, Emitter- und Emitterelektrodenherausführungs-Bereiche in einer selbstjustierenden (self-aligned) Weise gebildet werden, welches Verfahren Schritte enthält zum

Ausbilden eines eingebetteten Bereiches (23) bei einer Oberfläche eines halbleitenden Substrats (21) des ersten Leitungstyps (P), wobei der eingebettete Bereich vom entgegengesetzten Leitungstyp (N) ist,

Ausbilden einer ersten isolierenden Schicht (27), die in sich erste und zweite Öffnungen (28, 29) aufweist, welche sich zu dem eingebetteten Bereich (23) hin öffnen, auf der Oberfläche des Substrats (21),

Ausbilden einer halbleitenden Schicht (30, 31, 31'), die monokristalline erste und zweite vertiefte Bereiche (31, 31') in der ersten bzw. der zweiten Öffnung (28, 29) umfaßt und in den sonstigen Bereichen (30) polykristallin ist, über der ersten isolierenden Schicht (27), wobei die halbleitende Schicht vom entgegengesetzten Leitungstyp (N) ist,

Anreichern des zweiten monokristallinen vertieften Bereiches (31') der halbleitenden Schicht des entgegengesetzten Leitungstyps (N) mit einer Störstelle des entgegengesetzten Leitungstyps (N), um einen Kollektorelektrodenherausführungsteil (33) in der zweiten Öffnung (29) zu bilden,

Ausbilden einer zweiten isolierenden Schicht (34) und anschließend einer Nitridschicht (35) innerhalb der vertieften Bereiche (31, 31') der halbleitenden Schicht,

Ionenimplantieren einer Störstelle des ersten Leitungstyps (P) in die halbleitende Schicht hinein und anschließend selektiven Entfernen der halbleitenden Schicht, um zu bilden: einen ersten haltleitenden Schichtteil, der den aktiven Bereich, welcher innerhalb der ersten Öffnung (28) liegt, umfaßt, und einen Basiselektrodenherausführungsteil (38), der sich von der ersten Öffnung (28) fort erstreckt, sowie einen zweiten halbleitenden Teil, der den Kollektorelektrodenherausführungsteil (33) umfaßt,

wobei die zweite isolierende Schicht (34) und die Nitridschicht (35) als eine Ionenbremse dienen, die verhindert, daß Ionen während der Ionenimplantation in den aktiven Bereich implantiert werden, wodurch der Kollektor-Bereich (49) des entgegengesetzten Leitungstyps (N) erhalten bleibt,

Ausbilden einer Oxidschicht (39) über den ersten und zweiten halbleitenden Schichtteilen unter Benutzung der Nitridschicht (35) als eine Maske und anschließenden Entfernen der Nitridschicht (35),

Einführen einer Störstelle des ersten Leitungstyps (P) in den aktiven Bereich, um den Basis-Bereich (48) des ersten Leitungstyps zu bilden, wobei die Oxidschicht (39) als eine Maske benutzt wird,

Entfernen der zweiten isolierenden Schicht (34) und

Einführen einer Störstelle des entgegengesetzten Leitungstyps (N) in den Basis-Bereich (48), um den Emitter-Bereich (47) des entgegengesetzten Leitungstypys zu bilden.

2.  Verfahren nach Anspruch 1, bei dem eine polykristalline Siliziumschicht (42) zum Verhindern des Eindringens von Aluminium, das nachfolgend verwendet wird, um Basis-, Emitter- und Kollektorelektroden (44, 45, 46) auszubilden, auf der halbleitenden Schicht nach dem Entfernen der zweiten isolierenden Schicht (34) gebildet wird.

# FIG. 1

# FIG. 2

FIG. 3A

FIG. 3B

FIG. 3C

FIG. 3D

9

FIG. 3E

FIG. 3F

FIG. 3G

FIG. 3H

FIG. 3I

FIG. 3J

FIG. 3K

FIG. 3L

FIG. 3M

## FIG. 4